(19) Europäisches Patentamt / European Patent Office / Office européen des brevets

(11) **EP 3 555 571 B1**

(12) **EUROPÄISCHE PATENTSCHRIFT**

(45) Veröffentlichungstag und Bekanntmachung des Hinweises auf die Patenterteilung:
**24.02.2021   Patentblatt 2021/08**

(21) Anmeldenummer: **17787413.8**

(22) Anmeldetag: **23.10.2017**

(51) Int Cl.:
*G01D 3/08* (2006.01)     *G01D 5/14* (2006.01)
*G01D 5/20* (2006.01)

(86) Internationale Anmeldenummer:
**PCT/EP2017/076977**

(87) Internationale Veröffentlichungsnummer:
**WO 2018/108365 (21.06.2018 Gazette 2018/25)**

(54) **SENSORSYSTEM ZUR BESTIMMUNG MINDESTENS EINER ROTATIONSEIGENSCHAFT EINES UM MINDESTENS EINE ROTATIONSACHSE ROTIERENDEN ELEMENTS**

SENSOR SYSTEM FOR DETERMINING AT LEAST ONE ROTATION PROPERTY OF AN ELEMENT ROTATING ABOUT AT LEAST ONE ROTATIONAL AXIS

SYSTÈME DE CAPTEUR POUR DÉTERMINER AU MOINS UNE PROPRIÉTÉ DE ROTATION D'AU MOINS UN ÉLÉMENT ROTATIF TOURNANT AUTOUR D'AU MOINS UN AXE DE ROTATION

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **13.12.2016   DE 102016224856**

(43) Veröffentlichungstag der Anmeldung:
**23.10.2019   Patentblatt 2019/43**

(73) Patentinhaber: **Robert Bosch GmbH**
**70442 Stuttgart (DE)**

(72) Erfinder:
• **UTERMOEHLEN, Fabian**
**71229 Leonberg (DE)**
• **OSHINUBI, Dayo**
**71277 Rutesheim (DE)**
• **YASHAN, Andre**
**70191 Stuttgart (DE)**
• **LEIDICH, Stefan**
**71277 Rutesheim (DE)**

(56) Entgegenhaltungen:
**EP-A1- 0 900 997          DE-A1-102005 052 245**
**DE-A1-102012 200 195      DE-A1-102012 213 539**
**DE-A1-102012 222 316      US-A1- 2015 022 198**
**US-B2- 7 449 878**

**Beschreibung**

Stand der Technik

Aus dem Stand der Technik sind zahlreiche Sensoren bekannt, welche mindestens eine Rotationseigenschaft rotierender Elemente erfassen. Unter einer Rotationseigenschaft ist dabei allgemein eine Eigenschaft zu verstehen, welche die Rotation des rotierenden Elements zumindest teilweise beschreibt. Hierbei kann es sich beispielsweise um eine Winkelgeschwindigkeit, eine Drehzahl, eine Winkelbeschleunigung, einen Drehwinkel oder eine andere Eigenschaft handeln, welche eine kontinuierliche oder diskontinuierliche, gleichförmige oder ungleichförmige Rotation oder Drehung des rotierenden Elements charakterisieren kann. Beispiele derartiger Sensoren sind in Konrad Reif (Hrsg.): Sensoren im Kraftfahrzeug, 2. Auflage, 2012, Seiten 63-74 und 120-129 beschrieben.

Beispielsweise kann eine Lage einer Nockenwelle einer Brennkraftmaschine relativ zu einer Kurbelwelle mit einem so genannten Phasengeber mittels eines Hall-Sensors bestimmt werden. Typischerweise wird auf der sich drehenden Achse ein Geberrad angebracht. Auf dem Geberrad können sich Zähne befinden, die durch den Hall-Sensor abgetastet werden, wenn sich die Nockenwelle dreht. So wird in der DE 10 2012 213 539 A1 ein Verfahren zur Bestimmung einer Phasenlage einer verstellbaren Nockenwelle einer Brennkraftmaschine, die ein Geberrad und einen Nockenwellenversteller umfasst, beschrieben. Die Phasenlage der Nockenwelle wird anhand von durch das Geberrad ausgelöste Phasenflankeninterrupts und eines Modells, das abhängig von mindestens einer Betriebskenngröße des Nockenwellenverstellers ist, bestimmt.

Derartige Verfahren erlauben jedoch in der Regel keine kontinuierliche Positionserfassung. Eine absolute Winkelerfassung in einem Messbereich von 360° ist nicht möglich. Ebenfalls ist die Auflösung durch die geringen Durchmesser der verwendeten Geberräder limitiert. Durch diese geringen Durchmesser ergeben sich minimale Lückengrößen, die eingehalten werden müssen. Weiter ist eine absolute Positionsbestimmung nur in einem dynamischen Fall, bei Drehung des Geberrads möglich. Eine instantane Verfügbarkeit einer Winkelposition beim Einschalten der Spannungsversorgung, eine True-Power-On-Funktion, ist damit nicht gegeben. Insbesondere bei einem Start eines Motors der Brennkraftmaschine ist eine Position nicht exakt bekannt. Zudem weisen derartige Verfahren eine hohe Empfindlichkeit gegenüber magnetischen Störfeldern auf.

In der US 7,449,878 B2 wird ein induktiver Linear- und Rotations-PositionsSensor beschrieben. Es wird eine Vorrichtung mit einer Erregerspule und einer Empfängerspule beschrieben. Die Erregerspule wird durch eine Erregerquelle angeregt und erzeugt einen magnetischen Fluss. Die Empfängerspule erzeugt ein Empfangssignal durch eine induktive Kopplung zwischen der Erregerspule und der Empfängerspule

Die Druckschrift DE 10 2012 200195 A1 offenbart ein weiteres ähnliches Sensorsystem.

Trotz der durch derartige Sensorvorrichtungen bewirkten Verbesserungen besteht nach wie vor ein Verbesserungspotenzial. Derartige Sensorvorrichtungen können einen komplexen Aufbau aufweisen. So ist insbesondere ein einfacher Einbau und Ausbau der Sensorvorrichtungen nicht möglich.

Offenbarung der Erfindung

Im Rahmen der vorliegenden Erfindung wird daher ein Sensorsystem zur Bestimmung mindestens einer Rotationseigenschaft eines rotierenden Elements vorgeschlagen. Unter einem "Sensorsystem" wird im Rahmen der vorliegenden Erfindung grundsätzliche eine beliebige Vorrichtung verstanden, welche geeignet ist, die mindestens eine Rotationseigenschaft zu erfassen und welche beispielsweise mindestens ein elektrisches Messsignal entsprechend der erfassten Eigenschaft erzeugen kann, wie beispielsweise eine Spannung oder einen Strom. Auch Kombinationen von Eigenschaften können erfassbar sein.

Unter einer "Rotationseigenschaft" wird im Rahmen der vorliegenden Erfindung grundsätzlich eine Eigenschaft verstanden werden, welche die Rotation des rotierenden Elements zumindest teilweise beschreibt. Hierbei kann es sich beispielsweise um eine Winkelgeschwindigkeit, eine Drehzahl, eine Winkelbeschleunigung, eine Winkelposition oder eine andere Eigenschaften handeln, welche eine kontinuierliche oder diskontinuierliche, gleichförmige oder ungleichförmige Rotation oder Drehung des rotierenden Elements zumindest teilweise charakterisieren kann. Beispielsweise kann es sich bei der Rotationseigenschaft um eine Position, insbesondere eine Winkelposition, oder um eine Drehzahl oder um eine Kombination beider Größen handeln. Auch andere Eigenschaften und/oder andere Kombinationen von Eigenschaften können erfassbar sein. Unter einer "Winkelposition" wird im Rahmen der vorliegenden Erfindung grundsätzlich ein Drehwinkel einer rotationsfähigen Vorrichtung, beispielsweise des rotierenden Elements oder des Geberrads, bezüglich einer senkrecht auf der Rotationsachse stehenden Achse verstanden.

Das Sensorsystem kann insbesondere zum Einsatz in einem Kraftfahrzeug eingerichtet sein. Unter einem "rotierenden Element" wird im Rahmen der vorliegenden Erfindung grundsätzlich ein beliebiges Element verstanden, welches eine Rotationsachse aufweist und um diese rotiert. Beispielsweise kann das rotierende Element eine Welle in einer Antriebsmaschine sein, beispielsweise eine Nockenwelle. Beispielsweise kann eine Winkelposition einer Nockenwelle oder eine Drehzahl einer Nockenwelle oder eine Kombination beider Größen bestimmt werden.

Das Sensorsystem zur Bestimmung mindestens einer Rotationseigenschaft eines um mindestens eine Rotationsachse rotierenden Elements weist mindestens ein mit dem rotierenden Element verbindbares Geberrad auf. Das Geberrad weist ein Geberradprofil auf. Das Sensorsystem weist mindestens einen induktiven Positionssensor auf. Der induktive Positionssensor weist mindestens eine Spulenanordnung auf, welche mindestens eine Erregerspule und mindestens eine Empfängerspule umfasst. Das Sensorsystem weist weiterhin mindestens einen Phasengeber auf. Der Phasengeber weist mindestens einen Magnetfelderzeuger und mindestens ein Magnetsensorelement auf.

Unter einem "Geberrad" wird im Rahmen der vorliegenden Erfindung grundsätzlich ein beliebiges mit dem rotierenden Element verbindbares Bauelement verstanden, das eingerichtet ist, bei Verbindung mit dem rotierenden Element pro Umdrehung des rotierenden Elements mindestens ein messbares Signal, insbesondere eine Magnetfeldänderung, zu bewirken. Unter einem "Geberradprofil" wird im Rahmen der vorliegenden Erfindung grundsätzlich die Gesamtheit von Profilelementen und von zwischen den Profilelementen angeordneten Zwischenräumen des Geberrads verstanden. Unter einem "Profilelement" des Geberrads wird im Rahmen der vorliegenden Erfindung grundsätzlich eine beliebige Ausformung der Kontur des Geberrads verstanden, insbesondere eine Ausbuchtung, beispielsweise eine stiftförmige, eine zahnförmige oder eine zackenförmige Ausbuchtung, oder eine Einkerbung oder eine Aussparung, beispielsweise ein Loch.

Unter einem "induktiven Positionssensor" wird im Rahmen der vorliegenden Erfindung grundsätzlich ein beliebiger Sensor verstanden, der ein Messsignal entsprechend einer erfassten Eigenschaft erzeugen kann, insbesondere ein elektrisches Messsignal, beispielsweise eine Spannung oder einen Strom, wobei eine Erzeugung des Messsignals auf einer Änderung eines magnetischen Flusses beruht. Insbesondere kann die erfasste Eigenschaft eine Position, beispielsweise eine Winkelposition umfassen. Insbesondere kann es sich bei dem induktiven Positionssensor um einen induktiven Magnetsensor handeln. Auch andere Ausgestaltungen sind jedoch grundsätzlich möglich.

Unter einer "Spulenanordnung" wird im Rahmen der vorliegenden Erfindung grundsätzliche eine beliebige Vorrichtung verstanden, die mindestens eine Spule umfasst. Unter einer "Spule" wird im Rahmen der vorliegenden Erfindung grundsätzlich ein beliebiges Bauelement verstanden, welches eine Induktivität aufweist und geeignet ist, bei Stromfluss ein Magnetfeld zu erzeugen. Unter einer "Erregerspule" wird im Rahmen der vorliegenden Erfindung grundsätzlich eine Spule verstanden, welche bei Anlegen einer elektrischen Spannung und/oder eines elektrischen Stroms einen magnetischen Fluss erzeugt. Unter einer "Empfängerspule" wird im Rahmen der vorliegenden Erfindung grundsätzlich eine Spule verstanden, welche eingerichtet ist, aufgrund einer induktiven Kopplung zwischen Erregerspule und Empfängerspule ein Signal zu erzeugen, welches abhängig ist von der induktiven Kopplung.

Unter einem "Phasengeber" wird im Rahmen der vorliegenden Erfindung grundsätzlich ein beliebiger Sensor verstanden, der geeignet ist, mindestens einmal pro Umdrehung die Drehzahl und/oder die Winkelposition eines mit einem Signalgeber verbundenen, rotierenden Elements zu bestimmen. Unter einem "Signalgeber" wird im Rahmen der vorliegenden Erfindung grundsätzlich eine beliebige, sich auf dem rotierenden Element befindende oder mit dem rotierenden Element verbundene oder verbindbare Vorrichtung verstanden, die geeignet ist, pro Umdrehung des rotierenden Elements mindestens ein messbares Signal zu bewirken, beispielsweise eine Magnetfeldänderung. Beispielsweise kann das oben bereits beschriebene und weiter unten noch näher ausgeführte Geberrad, insbesondere das mindestens eine Profilement des Geberrads, als Signalgeber fungieren. Auch andere Ausgestaltungen sind möglich. So kann das rotierende Element beispielsweise auch einen optischen oder kapazitiven Signalgeber aufweisen.

Unter einem "Magnetfelderzeuger" wird im Rahmen der vorliegenden Erfindung grundsätzlich eine beliebige Vorrichtung verstanden, welche eingerichtet ist, ein Magnetfeld zu erzeugen, insbesondere ein zeitlich konstantes Magnetfeld. Die Erzeugung kann dauerhaft erfolgen oder auch zeitlich begrenzt. Insbesondere kann der Magnetfelderzeuger einen Permanentmagneten und/oder einen Elektromagneten aufweisen, beispielsweise eine stromdurchflossene Spule, insbesondere eine stromdurchflossene Spule mit einem Eisenkern, sein. Unter einem "Magnetsensorelement" wird im Rahmen der vorliegenden Erfindung grundsätzlich eine beliebige Vorrichtung verstanden, welche eingerichtet ist, mindestens eine Eigenschaft eines Magnetfeldes zu erfassen und welche beispielsweise mindestens ein elektrisches Messsignal entsprechend der erfassten Eigenschaft erzeugen kann, wie beispielsweise eine Spannung oder einen Strom. Auch Kombinationen von Eigenschaften können erfassbar sein. Insbesondere kann die erfasste Eigenschaft eine magnetische Feldstärke sein. Erfindungsgemäß weist das Magnetsensorelement mindestens ein Element auf ausgewählt aus der Gruppe bestehend aus: einem Hall-Element und einem magnetoresistiven Element.

Die Spulenanordnung kann auf mindestens einem Schaltungsträger angeordnet sein. Der Schaltungsträger kann im Wesentlichen koaxial zu der Rotationsachse angeordnet sein. Der Schaltungsträger kann das Geberrad oder ein Kreissegment des Geberrads im Wesentlichen kreisförmig oder kreissegmentförmig umgeben. Unter dem Begriff "im Wesentlichen kreisförmig" wird im Rahmen der vorliegenden Erfindung grundsätzlich verstanden, dass das beschriebene Bauelement einen Krümmungsradius aufweist. Der Krümmungsradius kann innerhalb des Bauelements um einen Wert von 0 % bis 80 %, bevorzugt von 0 % bis 50 %, mehr bevorzugt von 0 % bis 20 % und besonders bevorzugt von 0 % bis 5 % variieren. Insbesondere kann der Krümmungsradius auch konstant sein. Alternativ oder zusätzlich kann der Schaltungsträger auch aus zwei oder mehr Segmenten zusammengesetzt sein, welche beispielsweise jeweils eben oder auch gekrümmt ausgestaltet sein können und welche beispielsweise miteinander verbunden sein können. Die Segmente können insgesamt dann ebenfalls koaxial zur Rotationsachse angeordnet sein, auch wenn die einzelnen Segmente dann beispielsweise tangetial angeordnet sind.

Das Sensorsystem kann eingerichtet sein, die induktive Kopplung und/oder eine Änderung der induktiven Kopplung zwischen der Erregerspule und der Empfängerspule zu erfassen. Das Sensorsystem kann weiterhin eingerichtet sein, ein elektrisches Messsignal des Phasengebers zu erfassen. Bei dem elektrischen Messsignal kann es sich insbesondere um ein Spannungssignal handeln. Bei dem elektrischen Messsignal des Phasengebers kann es sich insbesondere um ein elektrisches Messsignal des Magnetsensorelements, insbesondere des Hallelements, handeln. Insbesondere kann das Sensorsystem eingerichtet sein, die durch eine Bewegung und/oder eine Position des Geberrads bewirkte induktive Kopplung und/oder die Änderung der induktiven Kopplung zwischen Erregerspule und Empfängerspule zu erfassen. Ferner kann das Sensorsystem eingerichtet sein, das durch die Position des Geberrads bewirkte elektrische Messsignal des Phasengebers zu erfassen. Weiterhin kann das Sensorsystem eingerichtet sein, aus der durch die Bewegung und/oder die Position des Geberrads bewirkten induktiven Kopplung und/oder Änderung der induktiven Kopplung zwischen Erregerspule und Empfängerspule eine Winkelposition des rotierenden Elements zu bestimmen. Ferner kann das Sensorsystem eingerichtet sein, mithilfe von mindestens einem, durch die Position des Geberrads bewirkten elektrischen Messsignal des Phasengebers die Winkelposition und/oder die Drehzahl des rotierenden Elements zu bestimmen. Insbesondere kann das Sensorsystem eingerichtet sein, mit mindestens zwei durch die Position des Geberrads bewirkten elektrischen Messsignalen des Phasengebers die Winkelposition und/oder die Drehzahl des rotierenden Elements zu bestimmen. Insbesondere kann das Sensorsystem eingerichtet sein, eine Verfügbarkeit der Winkelposition des rotierenden Elements bei einem Einschalten einer Spannungsversorgung zu ermöglichen. Die gerade beschriebene Eigenschaft der Verfügbarkeit bei Einschalten der Spannungsversorgung wird auch mit dem englischen Begriff der "True-Power-On"-Funktion bezeichnet. Das Sensorsystem kann insbesondere eine "True-Power-On"-Funktion besitzen. Insbesondere kann das Sensorsystem eingerichtet sein, das elektrische Signal des Magnetsensorelements an ein Steuergerät weiterzugeben. Ferner kann das Sensorsystem eine Auswerteeinheit aufweisen. Die Auswerteeinheit kann mindestens eine Auswerteschaltung aufweisen. Die Auswerteeinheit kann mit der Spulenanordnung auf einem gemeinsamen Schaltungsträger angeordnet sein. Die Auswerteeinheit kann auch von der Spulenanordnung getrennt auf einem weiteren Schaltungsträger angeordnet sein.

Die Erregerspule kann mindestens eine Erregerwindung aufweisen. Die Empfängerspule kann mindestens eine Empfängerwindung aufweisen. Eine Empfängerwindung kann mindestens zwei Teilwindungen umfassen. Die Teilwindungen können gegenläufig orientiert sein. Insbesondere kann die Empfängerspule aus einer Empfängerwindung bestehen, wobei die Empfängerwindung aus zwei Teilwindungen besteht, wobei die Teilwindungen gegenläufig orientiert sind. Das Sensorsystem kann eine Vielzahl von Empfängerspulen aufweisen, beispielsweise ein Empfängerspulensystem, insbesondere eine Sinus-/Cosinussystem oder eine Mehrphasensystem. Auch andere Spulensysteme sind grundsätzlich denkbar. Das Sensorsystem kann eingerichtet sein, ein Sinussystem, ein Cosinussystem oder ein Mehrphasensystem zur Detektion abzubilden. Insbesondere kann das Sensorsystem eine Anzahl von 1 bis 100 Empfängerspulen, bevorzugt von 2 bis 10 Empfängerspulen, besonders bevorzugt von 3 Empfängerspulen aufweisen. Insbesondere können die Empfängerspulen aus jeweils mindestens zwei Teilwindungen bestehen, wobei die unmittelbar aufeinanderfolgenden Teilwindungen gegenläufig orientiert sein können. Insbesondere können die Empfängerspulen zueinander eine elektrische Phasenverschiebung aufweisen. Insbesondere können die Teilwindungen der verschiedenen Empfängerspulen gemäß der elektrischen Phasenverschiebung gegeneinander versetzt angeordnet sein.

Der Magnetfelderzeuger kann insbesondere mindestens ein Element umfassen ausgewählt aus der Gruppe bestehend aus einem Permanentmagneten und einem Elektromagneten. Das Geberrad weist mindestens ein Profilelement auf. Das Profilelement kann ausgewählt sein aus der Gruppe bestehend aus: einer Ausbuchtung, insbesondere einer stiftförmigen, einer zahnförmigen oder einer zackenförmigen Ausbuchtung, beispielsweise einem Zahn; einer Einkerbung; einer Aussparung, beispielsweise einem Loch; einer in der Breite des Geberrads profilierten Spur. Unter einer Breite des Geberrads kann hierbei eine Höhe eines Zylindermantels des Geberrads verstanden werden. Insbesondere kann das Geberrad eine Mehrzahl von Profilelementen aufweisen. Insbesondere kann die Mehrzahl von Profilelementen über den Umfang des Geberrads verteilt angeordnet sein. Beispielsweise können die Profilelemente äquidistant und/oder periodisch angeordnet sein. Auch andere Ausgestaltungen des Geberradprofils sind möglich. So können die Profilelemente auch nicht äquidistant und/oder nicht periodisch angeordnet sein. Das Geberrad kann mindestens ein Material aufweisen ausgewählt aus der Gruppe bestehend aus: einem elektrisch leitfähigen Material; einem ferromagnetischen Material; einem Metall. Insbesondere kann das Profilelement mindestens ein Material aufweisen ausgewählt aus der Gruppe bestehend aus: einem elektrisch leitfähigen Material; einem ferromagnetischen Material; einem Metall. Insbesondere kann das Sensorsystem mindestens zwei Geberräder aufweisen. Insbesondere können die Geberräder unterschiedliche Geberradprofile aufweisen.

Der Schaltungsträger kann das Geberrad und/oder ein Kreissegment des Geberrads im Wesentlichen kreisförmig umgeben. Insbesondere kann die Spulenanordnung, insbesondere die auf dem Schaltungsträger angeordnete Spulenanordnung, in mindestens einer Winkelposition des Geberrads mindestens ein Profilelement und mindestens einen Zwischenraum zwischen zwei Profilelementen des Geberrads abdecken. Der Schaltungsträger kann flexibel ausgestaltet sein. Insbesondere kann der Schaltungsträger ein flexibles Material umfassen. Der Schaltungsträger kann ausgewählt sein aus der Gruppe bestehend aus: einer Leiterplatte, insbesondere einer Starrflex-Leiterplatte, beispielsweise einer gebogenen Starrflex-Leiterplatte; einer starren Leiterplatte, insbesondere einer starren Leiterplatte mit Einkerbungen; einer Leiterkarte; einer Platine und einer gedruckten Schaltung, insbesondere einem "printed circuit board" (PCB). Insbesondere kann der Schaltungsträger mindestens zwei ebene Flächen aufweisen. Die ebenen Flächen können in einem Winkel zueinander angeordnet sein. Insbesondere kann der Schaltungsträger mindestens ein Verbindungselement aufweisen, wobei das Verbindungselement die ebenen Flächen miteinander verbindet. Insbesondere können die ebenen Flächen einen Winkel einschließen, wobei der Winkel einen Wert von 10° bis 180°, bevorzugt von 30° bis 150° und besonders bevorzugt von 60° bis 120° aufweisen kann. Weiterhin kann der Schaltungsträger in einem Gehäuse, insbesondere in einem Spritzgussgehäuse, angeordnet sein.

Das rotierende Element weist mindestens eine Rotationsachse auf. Das mindestens eine Geberrad ist mit dem rotierenden Element verbindbar. Auch das Geberrad kann eine Rotationsachse aufweisen. Insbesondere können das rotierende Element und das Geberrad eine gemeinsame Rotationsachse aufweisen. Das Geberrad kann konzentrisch um das rotierende Element angeordnet sein. Das Geberrad kann eine zylindrische Grundform aufweisen. Die Rotationsachse kann eine Symmetrieachse parallel zu einer Höhe des Zylinders sein. Das Geberrad kann mit dem rotierenden Element verbunden sein. Das Geberrad kann auf dem rotierenden Element befestigt sein, beispielsweise durch mindestens ein Befestigungselement. Das Geberrad kann konzentrisch auf dem rotierenden Element befestigt sein. Bei einer Rotationsbewegung des rotierenden Elements kann das Geberrad mit dem rotierenden Element gemeinsam rotieren. Eine Position, insbesondere eine Winkelposition, des Geberrads kann einer Position, insbesondere einer Winkelposition, des rotierenden Elements entsprechen.

In einem weiteren Aspekt der vorliegenden Erfindung wird ein Verfahren zur Bestimmung einer Rotationseigenschaft eines um mindestens eine Rotationsachse rotierenden Elements vorgeschlagen. Das Verfahren umfasst die Verwendung mindestens eines mit dem rotierenden Element verbindbaren Geberrads, wobei das Geberrad ein Geberradprofil aufweist. Das Verfahren umfasst die folgenden Schritte, bevorzugt in der angegebenen Reihenfolge. Auch eine andere Reihenfolge ist grundsätzlich möglich. Weiterhin können einer oder mehrere oder alle Verfahrensschritte auch wiederholt durchgeführt werden. Weiterhin können zwei oder mehrere der Verfahrensschritte auch ganz oder teilweise zeitlich überlappend oder gleichzeitig durchgeführt werden. Das Verfahren kann, zusätzlich zu den genannten Verfahrensschritten auch weitere Verfahrensschritte umfassen.

Die Verfahrensschritte sind:

a) eine Aufnahme mindestens eines induktiven Signals mittels mindestens eines induktiven Positionssensor, wobei der induktive Positionssensor mindestens eine Spulenanordnung aufweist, umfassen mindestens eine Erregerspule und mindestens eine Empfängerspule; und

b) eine Aufnahme mindestens eines Phasengebersignals mittels mindestens eines Phasengebers, wobei der Phasengeber mindestens einen Magnetfelderzeuger und mindestens ein Magnetsensorelement aufweist.

Das Verfahren kann insbesondere unter Verwendung eines Sensorsystems gemäß der vorliegenden Erfindung, also gemäß einer der oben genannten Ausführungsformen oder gemäß einer der unten noch näher beschriebenen Ausführungsformen, durchgeführt werden. Dementsprechend kann für Definitionen und optionale Ausgestaltungen weitgehend auf die Beschreibung des Sensorelements verwiesen werden. Auch andere Ausgestaltungen sind jedoch grundsätzlich möglich.

Insbesondere kann das induktive Signal mindestens ein Signal umfassen ausgewählt aus der Gruppe bestehend aus einer induktiven Kopplung in der Spulenanordnung und einer Änderung einer induktiven Kopplung in der Spulenanordnung. Weiterhin kann das Phasengebersignal mindestens ein Spannungssignal des Magnetsensorelements umfassen. Insbesondere können die induktive Kopplung und/oder die Änderung der induktiven Kopplung in der Spulenanordnung von einer Bewegung und/oder einer Position des Geberrad abhängen. Insbesondere kann das Phasengebersignal von einer Position des Geberrads abhängen. Weiterhin kann das Verfahren eine Bestimmung der Winkelposition des rotierenden Elements mithilfe der erfassten, von der Position und/oder der Bewegung des Geberrads abhängigen induktiven Kopplung und/oder Änderung der induktiven Kopplung in der Spulenanordnung umfassen. Weiterhin kann das Verfahren eine Bestimmung der Winkelposition und/oder der Drehzahl des rotierenden Elements mithilfe von mindestens einem durch die Position des Geberrads bewirkten Phasengebersignal umfassen. Weiterhin kann das Verfahren das Aufbereiten des mindestens einen erfassten Phasengebersignals durch eine Auswerteschaltung umfassen. Ferner kann das Verfahren das Weiterleiten des mindestens einen erfassten Phasengebersignals an ein Steuergerät umfassen.

Vorteile der Erfindung

Die vorgeschlagene Vorrichtung und das vorgeschlagene Verfahren weisen gegenüber bekannten Vorrichtungen und Verfahren zahlreiche Vorteile auf. Insbesondere kann im Rahmen der vorliegenden Erfindung ein induktiver Positionssensor, insbesondere ein Absolutwinkelsensor, mit einem Phasengeber kombiniert werden. Es ist möglich, dass die erfindungsgemäße Anordnung des induktiven Positionssensor und des Phasengebers einen im Vergleich zum Stand der Technik deutlichen Vorteil im Ein- und Ausbau liefert, insbesondere bei Nutzung des Sensorsystems zur Nockenwellenpositionserfassung. So ist es insbesondere möglich, dass kein zusätzlicher Bauraum benötigt wird. Weiterhin ist es möglich, dass das Sensorsystem, beispielsweise die Sensoranordnung, im Gegensatz zum Stand der Technik nicht den kompletten Bereich des rotierenden Elements, beispielsweise der drehenden Welle, umschließen muss, sondern ihr nur radial in einem Kreissegment gegenüberstehen kann. Es ist möglich, dass ein erfindungsgemäßes Sensorsystem kostengünstig ist. Weiterhin ist es möglich, dass ein Messbereich eines erfindungsgemäßen Sensorsystems durch eine Auswertung mit zwei oder mehreren Geberrädern und/oder unterschiedlichen Geberradprofilen, insbesondere unterschiedlicher Zahnanzahl, zu einer Erfassung einer Winkelposition, insbesondere zu einer absoluten Winkelerfassung, eines Geberrads und/oder eines rotierenden Elements, insbesondere einer Wellenposition, auf 360° erweitert werden kann, beispielsweise mithilfe des Noniusprinzips (Vernier-Verfahren). Insbesondere kann die Spulenanordnung, insbesondere die auf dem Schaltungsträger angeordnete Spulenanordnung, in mindestens einer Winkelposition des Geberrads mindestens ein Profilelement und mindestens einen Zwischenraum zwischen zwei Profilelementen des Geberrads abdecken. Insbesondere kann ein Öffnungswinkel $\alpha$ der Spulenanordnung mindestens einem Öffnungswinkel $\beta$ eines Kreissegments des Geberrads, umfassend mindestens ein Profilelement und ein mindestens einen Zwischenraum zwischen zwei Profilelementen, entsprechen. Es ist möglich, dass dadurch eine maximale Winkelauflösung abgebildet werden kann.

Es ist möglich, dass ein erfindungsgemäßes Sensorsystem sowohl eine Winkelposition des rotierenden Elements, insbesondere einen Absolutwinkel, als auch mithilfe des Phasengebers, echtzeitfähige Triggersignale, beispielsweise für das Motorsteuergerät, liefern kann. Es ist möglich, dass dies durch einen alleinigen Einsatz eines induktiven Positionssensors, insbesondere eines induktiven Winkelsensors, durch die analoge und digitale Signalverarbeitung mit entsprechender Verarbeitungszeit nicht gewährleistet werden kann.

Ferner ist es möglich, dass ein erfindungsgemäßes Sensorsystem durch die Kombination des induktiven Positionssensors und des Phasengebers eine im Vergleich zum Stand der Technik höhere Genauigkeit bieten kann. Weiter kann es möglich sein, dass mithilfe eines erfindungsgemäßen Sensorsystems Anforderungen an funktionale Sicherheit, insbesondere auch in Bezug auf Verfügbarkeit, leichter zu erfüllen sind, insbesondere da bei Ausfall des induktiven Positionssensors oder des Phasengebers, der jeweils andere Sensor, also insbesondere der Phasengeber oder der induktive Positionssensor, Signale zur Motorsteuerung, insbesondere mit geringerer Genauigkeit, liefern kann. Dies kann beispielsweise einem Notlauf ohne größere Performanceverluste entsprechen. Weiterhin ist es möglich, dass Schleppfehler des induktiven Positionssensors, insbesondere des Absolutwinkelsensors, bei höheren Drehzahlen kompensiert werden können. Ferner ist es möglich, dass Messfehler des Phasengebers, insbesondere des Magnetfeldsensors, aufgrund von magnetischen Störfeldern im Betrieb durch den induktiven Positionssensor, insbesondere durch den induktiven Winkelsensor, korrigiert werden können, da dieser eine hohe Magnetfeldrobustheit aufweisen kann. Weiterhin ist es möglich, dass ein erfindungsgemäßes Sensorsystem eine Verfügbarkeit der Winkelposition, insbesondere der absoluten Winkelposition, des rotierenden Elements bei einem Einschalten einer Spannungsversorgung ermöglichen kann. Insbesondere ist es möglich, dass ein erfindungsgemäßes Sensorsystem über eine True-Power-On-Funktion verfügen kann. Eine True-Power-On-Funktion wird vom Orginalausrüstungshersteller, welcher auch mit dem englischen Begriff des "Original Equipment Manufacturer" (OEM) bezeichnet wird, zunehmend gefordert.

Kurze Beschreibung der Zeichnungen

Weitere optionale Einzelheiten und Merkmale der Erfindung ergeben sich aus der nachfolgenden Beschreibung bevorzugter Ausführungsbeispiele, welche in den Figuren schematisch dargestellt sind.
Es zeigen:

| | |
|---|---|
| Figur 1 | eine schematische Darstellung eines Ausführungsbeispiels eines erfindungsgemäßen Sensorsystems in Draufsicht; |
| Figuren 2 und 3 | je eine schematische Darstellung eines Ausführungsbeispiels einer Spulenanordnung; |
| Figur 4 | eine schematische Darstellung eines Ausführungsbeispiels eines Schaltungsträgers; und |
| Figuren 5A, 5B und 6 | schematische Darstellungen von Ausführungsbeispielen eines Geberrads mit Geberradprofil und eines weiteren Geberradprofils (Figur 6). |

Ausführungsformen der Erfindung

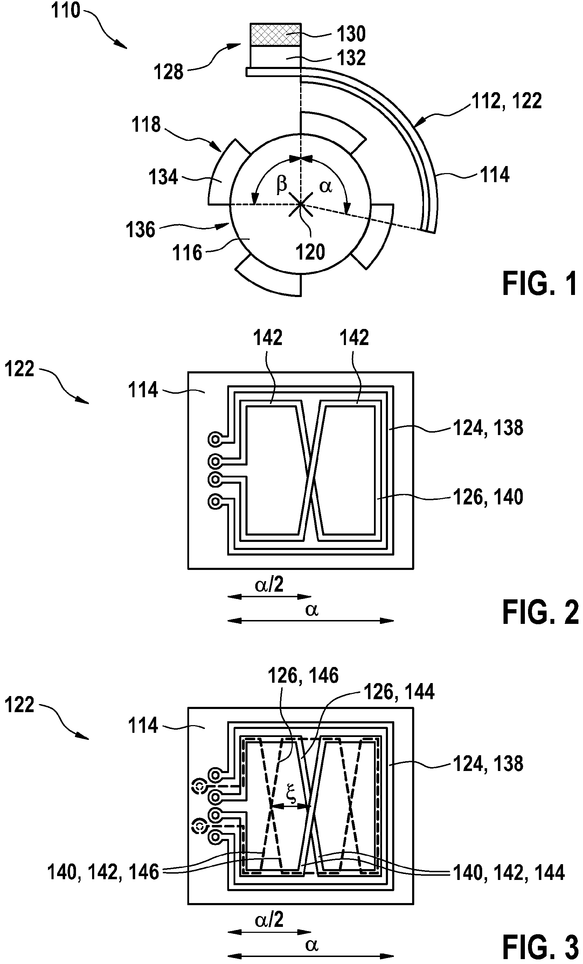

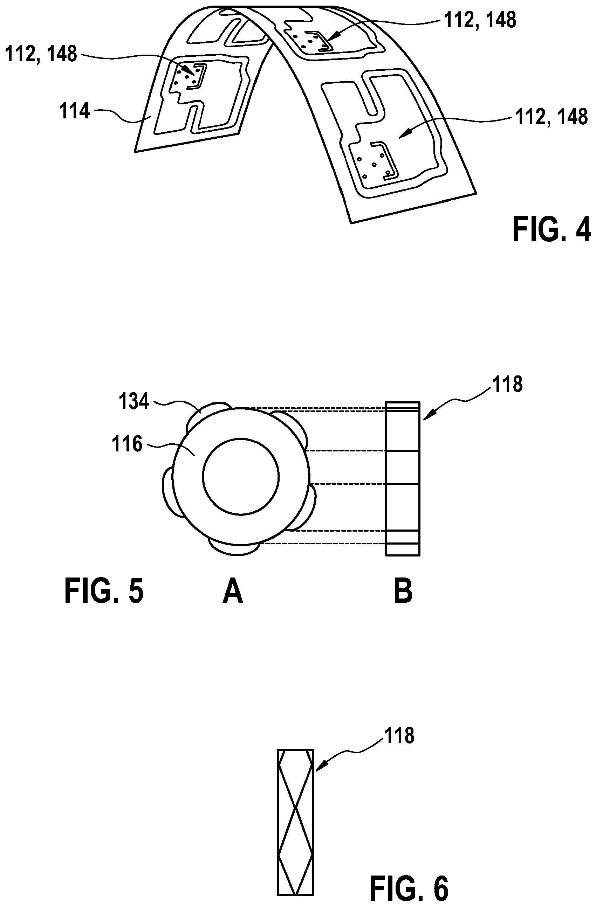

Figur 1 zeigt eine schematische Darstellung eines Ausführungsbeispiels eines erfindungsgemäßen Sensorsystems 110 in Draufsicht. Figuren 2 und 3 zeigen je eine schematische Darstellung eines Ausführungsbeispiels einer Spulenanordnung 112 zur Verwendung in dem Sensorsystem 110 nach Figur 1. Figur 4 zeigt eine schematische Darstellung eines Ausführungsbeispiels eines Schaltungsträgers 114, welcher ebenfalls in dem Sensorsystem 110 nach Figur 1 eingesetzt werden kann. Die Figuren 5A, 5B und 6 zeigen schematisch Ausführungsbeispiele eines Geberrads 116 mit Geberradprofil 118, welche ebenfalls in dem Sensorsystem 110 nach Figur 1 einsetzbar sind. Diese Figuren werden im Folgenden gemeinsam erläutert.

Das Sensorsystem 110 kann insbesondere zum Einsatz in einem Kraftfahrzeug eingerichtet sein. Insbesondere kann das Sensorsystem 110 zur Erfassung mindestens einer Rotationseigenschaft einer Nockenwelle eingerichtet sein. Beispielsweise kann das Sensorsystem 110 eingerichtet sein, eine Winkelposition der Nockenwelle und/oder eine Drehzahl der Nockenwelle zu erfassen. Das Sensorsystem 110 kann insbesondere ein oder mehrere in den Figuren nicht dargestellte weitere Funktionselemente umfassen, wie beispielsweise Elektroden, Elektrodenzuleitungen und Kontakte, mehrere Schichten, Heizelemente oder andere Elemente, wie beispielsweise in dem oben genannten Stand der Technik gezeigt.

Das Sensorsystem 110 zur Bestimmung mindestens einer Rotationseigenschaft eines um mindestens eine Rotationsachse 120 rotierenden Elements weist mindestens ein mit dem rotierenden Element verbindbares Geberrad 116 auf. Das Geberrad 116 weist ein Geberradprofil 118 auf. Das Sensorsystem 110 weist mindestens einen induktiven Positionssensor 122 auf. Der induktive Positionssensor 122 weist mindestens eine Spulenanordnung 112 auf, welche mindestens eine Erregerspule 124 und mindestens eine Empfängerspule 126 umfasst. Das Sensorsystem 110 weist weiterhin mindestens einen Phasengeber 128 auf. Der Phasengeber 128 weist mindestens einen Magnetfelderzeuger 130 und mindestens ein Magnetsensorelement 132 auf.

Figur 1 zeigt unter anderem den Phasengeber 128 mit Magnetfelderzeuger 130 und Magnetsensorelement 132. Der Magnetfelderzeuger 130 kann mindestens ein Element umfassen ausgewählt aus der Gruppe bestehend aus: einem Permanentmagneten; einem Elektromagneten, beispielsweise einer stromdurchflossenen Spule, insbesondere einer stromdurchflossenen Spule mit einem Eisenkern. Das Magnetsensorelement 132 weist mindestens ein Element rauf ausgewählt aus der Gruppe bestehend aus: einem Hall-Element und einem magnetoresistiven Element. Die Spulenanordnung 112 kann auf mindestens einem Schaltungsträger 114 angeordnet sein, wie in den Figuren 2 und 3 zu sehen. Der Schaltungsträger 114 kann im Wesentlichen koaxial zu der Rotationsachse 120 angeordnet sein, wie in Figur 1 gezeigt. Der Schaltungsträger 114 kann das Geberrad 116 oder ein Kreissegment des Geberrads 116 im Wesentlichen kreisförmig umgeben, wie ebenfalls in Figur 1 zu sehen. Insbesondere kann die Spulenanordnung 112, insbesondere die auf dem Schaltungsträger 114 angeordnete Spulenanordnung 112, in mindestens einer Winkelposition des Geberrads 116 mindestens ein Profilelement 134 und mindestens einen Zwischenraum 136 zwischen zwei Profilelementen 134 des Geberrads 116 abdecken. Insbesondere kann ein in den Figuren 1, 2 und 3 dargestellter Öffnungswinkel $\alpha$ der Spulenanordnung 112 mindestens einem ebenfalls in Figur 1 dargestellten Öffnungswinkel $\beta$ des Kreissegments des Geberrads 116, umfassend mindestens ein Profilelement 134 und ein mindestens einen Zwischenraum 136 zwischen zwei Profilelementen 134, entsprechen. Es ist möglich, dass dadurch eine maximale Winkelauflösung abgebildet werden kann.

Der Schaltungsträger 114 kann flexibel ausgestaltet sein. Beispielsweise kann der Schaltungsträger biegsam und/oder gebogen ausgestaltet sein, insbesondere kreisförmig oder kreissegmentförmig, wie in Figur 4 gezeigt. Insbesondere kann der Schaltungsträger 114 ein flexibles Material umfassen. Der Schaltungsträger 114 kann ausgewählt sein aus der Gruppe bestehend aus: einer Leiterplatte, insbesondere einer Starrflex-Leiterplatte, beispielsweise einer gebogenen Starrflex-Leiterplatte; einer starren Leiterplatte, insbesondere einer starren Leiterplatte mit Einkerbungen; einer Leiterkarte; einer Platine und einer gedruckten Schaltung, insbesondere einem "printed circuit board" (PCB). Weiterhin kann der Schaltungsträger 114 in einem hier nicht gezeigten Gehäuse, insbesondere in einem Spritzgussgehäuse, angeordnet sein.

Die Figuren 2 und 3 zeigen unter anderem beispielhaft zwei verschiedene Spulenanordnungen 112. Die Erregerspule 124 kann mindestens eine Erregerwindung 138 aufweisen. Die Empfängerspule 126 kann mindestens eine Empfängerwindung 140 aufweisen. Die Empfängerwindung 140 kann mindestens zwei Teilwindungen 142 umfassen. Die Teilwindungen 142 können gegenläufig orientiert sein. Insbesondere kann die Empfängerspule 126 aus einer Empfängerwindung 140 bestehen, wobei die Empfängerwindung 140 aus zwei Teilwindungen 142 besteht, wobei die Teilwindungen 142 gegenläufig orientiert sind. Das Sensorsystem 110 kann eine Vielzahl von Empfängerspulen 126 aufweisen, beispielsweise ein Empfängerspulensystem, insbesondere ein Sinus-/Cosinussystem oder eine Mehrphasensystem. Auch andere Spulensysteme sind grundsätzlich denkbar. Das Sensorsystem 110 kann eingerichtet sein, ein Sinussystem, ein Cosinussystem oder ein Mehrphasensystem zur Detektion abzubilden. Insbesondere kann das Sensorsystem 110 eine Anzahl von 1 bis 100 Empfängerspulen 126, bevorzugt von 2 bis 10 Empfängerspulen 126, besonders bevorzugt von 3 Empfängerspulen 126 aufweisen. Insbesondere können die Empfängerspulen 126 aus jeweils mindestens zwei Teilwindungen 142 bestehen, wobei die unmittelbar aufeinanderfolgenden Teilwindungen 142 jeweils gegenläufig orientiert sein können. Insbesondere können die Empfängerspulen 126 zueinander eine elektrische Phasenverschiebung aufweisen. Insbesondere können die jeweils mindestens eine Empfängerwindung 140 der Empfängerspulen 126, insbesondere die gegenläufig orientierten Teilwindungen 142, gemäß der elektrischen Phasenverschiebung gegeneinander versetzt angeordnet sein, wie in Figur 3 beispielhaft für ein Zweiphasensystem, umfassend eine erste Empfängerspule 144 und eine zweite Empfängerspule 146, dargestellt. Eine Versetzung ξ, insbesondere eine geometrische Verdrehung, der zweiten Empfängerspule 146 gegen die erste Empfängerspule 144, insbesondere der Teilwindungen 140 der zweiten Empfängerspule 146 gegen die Teilwindungen 140 der ersten Empfängerspule 144, kann sich bei zwei Empfängerspulen 126 ergeben aus:

$$\xi = \alpha/4 \qquad\qquad (1)$$

Bei einem Mehrphasensystem, umfassend eine Anzahl m von mindestens 3 Empfängerspulen kann sich die Versetzung ξ ergeben aus:

$$\xi = \alpha/m \qquad\qquad (2)$$

In einem weiteren bevorzugten Ausführungsbeispiel kann das Sensorsystem 110 eine Erregerspule 124 und drei Empfängerspulen 126 aufweisen. Die Empfängerspulen 126 können aus jeweils mindestens zwei Teilwindungen 142 bestehen, wobei die unmittelbar aufeinanderfolgenden Teilwindungen gegenläufig orientiert sind. Die Empfängerspulen 126 können zueinander eine elektrische Phasenverschiebung von 120° auf weisen. Insbesondere können die Teilwindungen 142 der drei Empfängerspulen 126 entsprechend der elektrischen Phasenverschiebung gegeneinander versetzt angeordnet sein.

Die Figuren 5A und 5B zeigen in Draufsicht (Figur 5A) und in Seitenansicht (Figur 5B) beispielhafte ein Geberrad 116 mit Geberradprofil 118. Figur 6 zeigt in Seitenansicht eine alternative Ausgestaltung eines Geberradprofils 118. Das Geberrad 116 weist mindestens ein Profilelement 134 auf. Während die Profilelemente 134 bei der Ausgestaltung gemäß Figur 5B sich über eine gesamte Breite des Geberrads 116 hinweg erstrecken, sind die Profilelemente 134 bei der alternativen Ausgestaltung gemäß Figur 6 über die Breite profiliert und bilden eine in der Breite profilierte Spur. Beispielsweise können die Profilelemente 134, wie in Figur 6 erkennbar, jeweils eine rautenförmige Ausgestaltung aufweisen. Auch andere Formen sind jedoch denkbar. Das mindestens eine Profilelement 134 kann insbesondere ausgewählt sein aus der Gruppe bestehend aus: einer Ausbuchtung, insbesondere einer stiftförmigen, einer zahnförmigen oder einer zackenförmigen Ausbuchtung, beispielsweise einem Zahn; einer Einkerbung; einer Aussparung, beispielsweise einem Loch; eine in der Breite des Geberrads profilierten Spur. Das Geberrad 116 kann mindestens ein Material aufweisen ausgewählt aus der Gruppe bestehend aus: einem elektrisch leitfähigen Material; einem ferromagnetischen Material; einem Metall. Insbesondere kann das Profilelement 134 mindestens ein Material aufweisen ausgewählt aus der Gruppe bestehend aus: einem elektrisch leitfähigen Material; einem ferromagnetischen Material; einem Metall. Insbesondere kann das Sensorsystem 110 mindestens zwei Geberräder 116 aufweisen. Insbesondere können die Geberräder 116 unterschiedliche Geberradprofile 118 aufweisen.

Das Sensorsystem 110 kann eingerichtet sein, die induktive Kopplung und/oder eine Änderung der induktiven Kopplung zwischen der Erregerspule 124 und der Empfängerspule 126 zu erfassen. Das Sensorsystem 110 kann weiterhin eingerichtet sein, ein elektrisches Messsignal des Phasengebers 128 zu erfassen. Bei dem elektrischen Messsignal kann es sich insbesondere um ein Spannungssignal handeln. Bei dem elektrischen Messsignal des Phasengebers 128 kann es sich insbesondere um ein elektrisches Messsignal des Magnetsensorelements 132, insbesondere des Hallelements, handeln. Insbesondere kann das Sensorsystem 110 eingerichtet sein, die durch eine Bewegung und/oder eine Position des Geberrads 116 bewirkte induktive Kopplung und/oder die Änderung der induktiven Kopplung zwischen Erregerspule 124 und Empfängerspule 126 zu erfassen. Ferner kann das Sensorsystem 110 eingerichtet sein, das durch die Position des Geberrads bewirkte elektrische Messsignal des Phasengebers 128 zu erfassen. Weiterhin kann das Sensorsystem 110 eingerichtet sein, aus der durch die Bewegung und/oder die Position des Geberrads 116 bewirkten induktiven Kopplung und/oder Änderung der induktiven Kopplung zwischen Erregerspule 124 und Empfängerspule 126 eine Winkelposition des rotierenden Elements zu bestimmen. Ferner kann das Sensorsystem 110 eingerichtet sein, mithilfe von mindestens einem, durch die Position des Geberrads 116 bewirkten elektrischen Messsignal des Phasengebers 128 die Winkelposition und/oder die Drehzahl des rotierenden Elements zu bestimmen. Insbesondere kann das Sensorsystem 110 eingerichtet sein, mit mindestens zwei durch die Position des Geberrads 116 bewirkten elektrischen Messsignalen des Phasengebers 128 die Winkelposition und/oder die Drehzahl des rotierenden Elements zu bestimmen.

Insbesondere kann das Sensorsystem 110 eingerichtet sein, das elektrische Messsignal des Phasengebers 128 an ein hier nicht gezeigtes Steuergerät weiterzugeben. Ferner kann das Sensorsystem 110 eine Auswerteeinheit 148 aufweisen. Die Auswerteeinheit kann mindestens eine Auswerteschaltung aufweisen. Die Auswerteeinheit kann mit der Spulenanordnung 112 auf einem gemeinsamen Schaltungsträger 114 angeordnet sein, wie in Figur 4 gezeigt. Die Auswerteeinheit kann auch von der Spulenanordnung 112 getrennt auf einem weiteren Schaltungsträger 114 angeordnet sein.

Das rotierende Element weist mindestens eine Rotationsachse 120 auf. Das mindestens eine Geberrad 116 ist mit dem rotierenden Element verbindbar. Auch das Geberrad 116 kann eine Rotationsachse 120 aufweisen. Insbesondere können das rotierende Element und das Geberrad 116 eine gemeinsame Rotationsachse 120 aufweisen. Das rotierende Element und das Geberrad 116 können um die gemeinsame Rotationsachse 120 rotieren. Wie in Figur 1 gezeigt, kann das Geberrad 116 bei der Rotation die beispielsweise konzentrisch um das Geberrad 116 und/oder um das Kreissegment des Geberrads 116 angebrachte Spulenanordnung 112 des induktiven Positionssensors 122 überstreichen. An der Erregerspule 124 kann eine Erregerspannung anliegen. Die Erregerspule 124 kann beispielsweise mit einer Spannung von 0,5 bis 10 V, bevorzugt mit einer Spannung von 1,5 V beaufschlagt, sowie mit einer Frequenz von 1 MHz bis 10 MHz, besonders bevorzugt mit 5 MHz beaufschlagt sein. Die mindestens eine Empfängerspule 126 kann mindestens zwei gegenläufig orientierte Teilwindungen 142 aufweisen. Die in der Empfängerspule 126 induzierte Spannung kann auch bei mit Spannung beaufschlagter Erregerspule 124 null sein, beispielsweise bei Abwesenheit des Geberrads 116. Das Geberradprofil 118 kann beim Überstreichen der Spulenanordnung 112 die induktive Kopplung zwischen der Erregerspule 124 und der Empfängerspule 126 ändern. Nach dem erfindungsgemäßen Verfahren erfolgt in diesem Ausführungsbeispiel die Aufnahme mindestens eines induktiven Signals durch den induktiven Positionssensor 122, beispielsweise eines Spannungssignals, entsprechend der induktiven Kopplung und/oder der Änderung der induktiven Kopplung, welches durch die Position des Geberrads 116 und/oder die Bewegung des Geberrads 116 bewirkt werden kann. Weiterhin kann das Verfahren die Bestimmung der Winkelposition des Geberrads 116 umfassen. Die Winkelposition des Geberrads 116 kann einer Winkelposition des rotierenden Elements entsprechen. Insbesondere kann das Sensorsystem 110 eingerichtet sein, eine Verfügbarkeit der Winkelposition des rotierenden Elements bei einem Einschalten einer Spannungsversorgung zu ermöglichen ("True-Power-On"-Funktion). Weiterhin kann das Geberrad 116 bei der Rotation das Magnetsensorelement 132 des Phasengebers 128 überstreichen. Das Geberradprofil 118 kann das vom Magnetfelderzeuger 130 erzeugte Magnetfeld beeinflussen. Nach dem erfindungsgemäßen Verfahren erfolgt in diesem Ausführungsbeispiel weiterhin die Aufnahme des Phasengebersignals, insbesondere des Spannungssignals des Magnetsensorelements 132, entsprechend des von der Position des Geberrads 116 bewirkten Magnetfelds. Weiterhin kann das Verfahren eine Bestimmung der Winkelposition des Geberrads und/oder eine Bestimmung der Drehzahl des rotierenden Elements mithilfe des mindestens einen Phasengebersignals umfassen. Weiterhin kann das Verfahren das Aufbereiten des mindestens einen erfassten Phasengebersignals durch eine hier nicht gezeigte Auswerteschaltung umfassen. Ferner kann das Verfahren das Weiterleiten des mindestens einen erfassten Phasengebersignals an ein in den Figuren ebenfalls nicht gezeigtes Steuergerät umfassen.

## Patentansprüche

1. Sensorsystem (110) zur Bestimmung mindestens einer Rotationseigenschaft eines um mindestens eine Rotationsachse rotierenden Elements, wobei das Sensorsystem (110) mindestens ein mit dem rotierenden Element verbindbares Geberrad (116) aufweist, wobei das Geberrad (116) ein Geberradprofil (118) aufweist, wobei das Sensorsystem (110) mindestens einen induktiven Positionssensor (122) aufweist, wobei der induktive Positionssensor (122) mindestens eine Spulenanordnung (112) aufweist, umfassend mindestens eine Erregerspule (124) und mindestens eine Empfängerspule (126),
**dadurch gekennzeichnet, dass**
das Sensorsystem (110) weiterhin mindestens einen Phasengeber (128) aufweist, wobei der Phasengeber (128) mindestens einen Magnetfelderzeuger (130) und mindestens ein Magnetsensorelement (132) aufweist und das Magnetsensorelement (132) mindestens ein Element aufweist, ausgewählt aus der Gruppe bestehend aus einem Hall-Element und einem magnetoresistiven Element.

2. Sensorsystem (110) nach Anspruch 1, wobei die Spulenanordnung (112) auf mindestens einem Schaltungsträger (114) angeordnet ist, wobei der Schaltungsträger (114) koaxial zu der Rotationsachse (120) angeordnet ist, wobei der Schaltungsträger (114) das Geberrad (116) oder ein Kreissegment des Geberrads (116) im Wesentlichen kreisförmig umgibt.

3. Sensorsystem (110) nach dem vorhergehenden Anspruch, wobei der Schaltungsträger (114) das Geberrad (116) oder ein Kreissegment des Geberrads (116) im Wesentlichen kreisförmig umgibt, wobei die Spulenanordnung (112) in mindestens einer Winkelposition mindestens ein Profilelement (134) und mindestens einen Zwischenraum (136)

zwischen zwei Profilelementen (134) des Geberrads (116) abdeckt.

4. Sensorsystem (110) nach einem der vorhergehenden Ansprüche, wobei das Sensorsystem (110) eingerichtet ist, eine induktive Kopplung und/oder eine Änderung einer induktiven Kopplung zwischen der Erregerspule (124) und der Empfängerspule (126) zu erfassen, wobei das Sensorsystem (110) weiterhin eingerichtet ist, ein elektrisches Messsignal des Phasengebers (128) zu erfassen.

5. Sensorsystem (110) nach dem vorhergehenden Anspruch, wobei das Sensorsystem (110) eingerichtet ist, die durch eine Bewegung und/oder eine Position des Geberrads (116) bewirkte induktive Kopplung und/oder bewirkte Änderung der induktiven Kopplung zwischen der Erregerspule (124) und der Empfängerspule (126) zu erfassen, wobei das Sensorsystem (110) weiterhin eingerichtet ist, ein durch die Position des Geberrads (116) bewirktes elektrisches Messsignal des Phasengebers (128) zu erfassen.

6. Sensorsystem (110) nach dem vorhergehenden Anspruch, wobei das Sensorsystem (110) eingerichtet ist, aus der durch die Bewegung und/oder durch die Position des Geberrads (116) bewirkten induktiven Kopplung und/oder bewirkten Änderung der induktiven Kopplung zwischen der Erregerspule (124) und der Empfängerspule (126) eine Winkelposition des rotierenden Elements zu bestimmen, wobei das Sensorsystem (110) weiterhin eingerichtet ist, mithilfe von mindestens einem durch die Position des Geberrads (116) bewirkten elektrischen Messsignal des Phasengebers (132) die Winkelposition und/oder eine Drehzahl des rotierenden Elements zu bestimmen.

7. Sensorsystem (110) nach dem vorhergehenden Anspruch, wobei das Sensorsystem (110) eingerichtet ist, eine Verfügbarkeit der absoluten Winkelposition des rotierenden Elements bei einem Einschalten einer Spannungsversorgung als True Power On-Funktion zu ermöglichen.

8. Sensorsystem (110) nach einem der vorhergehenden Ansprüche, wobei die mindestens eine Empfängerspule (126) aus mindestens zwei Teilwindungen (142) besteht, wobei die aufeinanderfolgenden Teilwindungen (142) gegenläufig orientiert sind.

9. Sensorsystem (110) nach einem der vorhergehenden Ansprüche wobei das Geberradprofil (118) mindestens ein Profilelement (134) aufweist.

10. Sensorsystem (110) nach einem der vorhergehenden Ansprüche, wobei das Sensorsystem (110) mindestens zwei Geberräder (116) aufweist.

11. Sensorelement (110) nach dem vorhergehenden Anspruch, wobei die zwei Geberräder (116) unterschiedliche Geberradprofile (118) aufweisen.

12. Verfahren zur Bestimmung mindestens einer Rotationseigenschaft eines um mindestens eine Rotationsachse (120) rotierenden Elements, wobei das Verfahren die Verwendung mindestens eines mit dem rotierenden Element verbindbaren Geberrads (116) umfasst, wobei das Geberrad (116) ein Geberradprofil (118) aufweist, wobei das Verfahren weiterhin folgende Schritte umfasst:

- eine Aufnahme mindestens eines induktiven Signals mittels mindestens eines induktiven Positionssensors (122), wobei der induktive Positionssensor (122) mindestens eine Spulenanordnung (112) aufweist, umfassend mindestens eine Erregerspule (124) und mindestens eine Empfängerspule (126); und
- eine Aufnahme mindestens eines Phasengebersignals mittels mindestens eines Phasengebers (128), wobei der Phasengeber (128) mindestens einen Magnetfelderzeuger (130) und mindestens ein Magnetsensorelement (132) aufweist und das Magnetsensorelement (132) mindestens ein Element aufweist, ausgewählt aus der Gruppe bestehend aus einem Hall-Element und einem magnetoresistiven Element.

13. Verfahren nach dem vorhergehenden Anspruch, wobei das Verfahren eine Bestimmung der Winkelposition des rotierenden Elements mithilfe der erfassten, von einer Position und/oder einer Bewegung des Geberrads (116) abhängigen induktiven Kopplung und/oder Änderung der induktiven Kopplung in der Spulenanordnung (112) umfasst, wobei das Verfahren weiterhin eine Bestimmung der Winkelposition und/oder einer Drehzahl des rotierenden Elements mithilfe von mindestens einem durch die Position des Geberrads (116) bewirkten Phasengebersignal umfasst.

**Claims**

1.  Sensor system (110) for determining at least one rotation property of an element which rotates about at least one rotational axis, wherein the sensor system (110) has at least one encoder wheel (116) which can be connected to the rotating element, wherein the encoder wheel (116) has an encoder wheel profile (118), wherein the sensor system (110) has at least one inductive position sensor (122), wherein the inductive position sensor (122) has at least one coil arrangement (112), comprising at least one exciter coil (124) and at least one receiver coil (126),
    **characterized in that**
    the sensor system (110) also has at least one phase sensor (128), wherein the phase sensor (128) has at least one magnetic field generator (130) and at least one magnetic sensor element (132), and the magnetic sensor element (132) has at least one element selected from the group composed of a Hall element and a magnetoresistive element.

2.  Sensor system (110) according to Claim 1, wherein the coil arrangement (112) is arranged on at least one circuit carrier (114), wherein the circuit carrier (114) is arranged coaxially with respect to the rotational axis (120), wherein the circuit carrier (114) surrounds the encoder wheel (116) or a circular segment of the encoder wheel (116) essentially in a circular shape.

3.  Sensor system (110) according to the preceding claim, wherein the circuit carrier (114) surrounds the encoder wheel (116) or a circular segment of the encoder wheel (116) essentially in a circular shape, wherein in at least one angular position the coil arrangement (112) covers at least one profile element (134) and at least one intermediate space (136) between two profile elements (134) of the encoder wheel (116).

4.  Sensor system (110) according to one of the preceding claims, wherein the sensor system (110) is configured to detect an inductive coupling and/or a change in an inductive coupling between the exciter coil (124) and the receiver coil (126), wherein the sensor system (110) is also configured to detect an electrical measurement signal of the phase sensor (128) .

5.  Sensor system (110) according to the preceding claim, wherein the sensor system (110) is configured to detect the inductive coupling, brought about by a movement and/or a position of the encoder wheel (116), and/or change which is brought about in the inductive coupling between the exciter coil (124) and the receiver coil (126), wherein the sensor system (110) is also configured to detect an electrical measurement signal of the phase sensor (128) which is brought about by the position of the encoder wheel (116).

6.  Sensor system (110) according to the preceding claim, wherein the sensor system (110) is configured to determine an angular position of the rotating element from the inductive coupling brought about by the movement and/or by the position of the encoder wheel (116) and/or change which is brought about in the inductive coupling between the exciter coil (124) and the receiver coil (126), wherein the sensor system (110) is also configured to determine the angular position and/or a rotational speed of the rotating element using at least one electrical measurement signal of the phase sensor (132) which is brought about by the position of the encoder wheel (116).

7.  Sensor system (110) according to the preceding claim, wherein the sensor system (110) is configured to permit availability of the absolute angular position of the rotating element when a voltage supply is switched on as a power on function.

8.  Sensor system (110) according to one of the preceding claims, wherein the at lest one receiver coil (126) is composed of at least two partial windings (142), wherein the successive partial windings (142) are oriented in opposite directions.

9.  Sensor system (110) according to one of the preceding claims, wherein the encoder wheel profile (118) has at least one profile element (134).

10. Sensor system (110) according to one of the preceding claims, wherein the sensor system (110) has at least two encoder wheels (116).

11. Sensor system (110) according to the preceding claim, wherein the two encoder wheels (116) have different encoder wheel profiles (118).

12. Method for determining at least one rotation property of an element which rotates about at least one rotational axis (120), wherein the method comprises the use of at least one encoder wheel (116) which can be connected to the rotating element, wherein the encoder wheel (116) has an encoder wheel profile (118), wherein the method also comprises the following steps:

- at least one inductive signal is picked up by means of at least one inductive position sensor (122), wherein the inductive position sensor (122) has at least one coil arrangement (112), comprising at least one exciter coil (124) and at least one receiver coil (126) ; and
- at least one phase sensor signal is picked up by means of at least one phase sensor (128), wherein the phase sensor (128) has at least one magnetic field generator (130) and at least one magnetic sensor element (132), and the magnetic sensor element (132) has at least one element selected from the group composed of a Hall element and a magnetoresistive element.

13. Method according to the preceding claim, wherein the method comprises determining the angular position of the rotating element using the detected inductive coupling and/or change in the inductive coupling in the coil arrangement (112), which is dependent on a position and/or movement of the encoder wheel (116), wherein the method also comprises determining the angular position and/or a rotational speed of the rotating element using at least one phase sensor signal which is brought about by the position of the encoder wheel (116).


**Revendications**

1. Système de capteur (110) permettant de déterminer au moins une propriété de rotation d'un élément en rotation autour d'au moins un axe de rotation, dans lequel le système de capteur (110) présente au moins une roue de capteur (116) pouvant être reliée à l'élément en rotation, la roue de capteur (116) présentant un profil de roue de capteur (118), dans lequel le système de capteur (110) présente au moins un capteur de position inductif (122), le capteur de position inductif (122) présentant au moins un agencement de bobines (112) comprenant au moins une bobine d'excitation (124) et au moins une bobine de réception (126),
   **caractérisé en ce que** le système de capteur (110) présente en outre au moins un capteur de phase (128), dans lequel le capteur de phase (128) présente au moins un générateur de champ magnétique (130) et au moins un élément de capteur magnétique (132) et l'élément de capteur magnétique (132) présente au moins un élément sélectionné dans le groupe composé d'un élément à effet Hall et d'un élément magnétorésistif.

2. Système de capteur (110) selon la revendication 1, dans lequel l'agencement de bobines (112) est disposé sur au moins un support de circuit (114), le support de circuit (114) étant agencé coaxialement à l'axe de rotation (120), le support de circuit (114) entourant la roue de capteur (116) ou un segment de cercle de la roue de capteur (116) de manière substantiellement circulaire.

3. Système de capteur (110) selon la revendication précédente, dans lequel le support de circuit (114) entoure la roue de capteur (116) ou un segment de cercle de la roue de capteur (116) de manière substantiellement circulaire, l'agencement de bobines (112) recouvrant dans au moins une position angulaire au moins élément profilé (134) et au moins un espace intermédiaire (136) entre deux éléments profilés (134) de la roue de capteur (116).

4. Système de capteur (110) selon l'une quelconque des revendications précédentes, dans lequel le système de capteur (110) est aménagé pour détecter un couplage inductif et/ou une modification d'un couplage inductif entre la bobine d'excitation (124) et la bobine de réception (126), le système de capteur (110) étant en outre aménagé pour détecter un signal de mesure électrique du capteur de phase (128).

5. Système de capteur (110) selon la revendication précédente, dans lequel le système de capteur (110) est aménagé pour détecter le couplage inductif et/ou une modification du couplage inductif entre la bobine d'excitation (124) et la bobine de réception (126) provoqué(e) par un mouvement et/ou par une position de la roue de capteur (116), le système de capteur (110) étant en outre aménagé pour détecter un signal de mesure électrique du capteur de phase (128), provoqué par la position de la roue de capteur (116).

6. Système de capteur (110) selon la revendication précédente, dans lequel le système de capteur (110) est aménagé pour déterminer à partir du couplage inductif et/ou d'une modification du couplage inductif entre la bobine d'excitation (124) et la bobine de réception (126), provoqué(e) par le mouvement et/ou par la position de la roue de capteur (116), une position angulaire de l'élément en rotation, le système de capteur (110) étant en outre aménagé pour déterminer à l'aide d'au moins un signal de mesure électrique du capteur de phase (132), provoqué par la position de la roue de capteur (116), la position angulaire et/ou une vitesse de rotation de l'élément en rotation.

**7.** Système de capteur (110) selon la revendication précédente, dans lequel le système de capteur (110) est aménagé pour permettre une disponibilité de la position angulaire absolue de l'élément en rotation lors de la mise en marche d'une alimentation en courant comme une fonction de mise sous tension réelle (« True Power On »).

**8.** Système de capteur (110) selon l'une quelconque des revendications précédentes, dans lequel ladite au moins une bobine de réception (126) est composée d'au moins deux enroulements partiels (142), les enroulements partiels (142) successifs étant orientés en sens opposé.

**9.** Système de capteur (110) selon l'une quelconque des revendications précédentes, dans lequel le profil de roue de capteur (118) présente au moins un élément profilé (134).

**10.** Système de capteur (110) selon l'une quelconque des revendications précédentes, dans lequel le système de capteur (110) présente au moins deux roues de capteur (116).

**11.** Elément de capteur (110) selon la revendication précédente, dans lequel les deux roues de capteur (116) présentent des profils de roue de capteur (118) différents.

**12.** Procédé permettant de déterminer au moins une propriété de rotation d'un élément en rotation autour d'un axe de rotation (120), le procédé comprenant l'utilisation d'au moins une roue de capteur (116) pouvant être reliée à l'élément en rotation, la roue de capteur (116) présentant un profil de roue de capteur (118), le procédé comprenant en outre les étapes suivantes consistant à :

- enregistrer au moins un signal inductif au moyen d'au moins un capteur de position inductif (122), le capteur de position inductif (122) présentant au moins un agencement de bobines (112) comprenant au moins une bobine d'excitation (124) et au moins une bobine de réception (126) ; et
- enregistrer au moins un signal de capteur de phase au moyen d'au moins un capteur de phase (128), le capteur de phase (128) présentant au moins un générateur de champ magnétique (130) et au moins un élément de capteur magnétique (132), et l'élément de capteur magnétique (132) présentant au moins un élément sélectionné dans le groupe composé d'un élément à effet Hall et d'un élément magnétorésistif.

**13.** Procédé selon la revendication précédente, dans lequel le procédé comprend une détermination de la position angulaire de l'élément en rotation à l'aide du couplage inductif et/ou d'une modification du couplage inductif dans l'agencement de bobines (112), détecté(e), dépendant d'une position et/ou d'un mouvement de la roue de capteur (116), le procédé comprenant en outre une détermination de la position angulaire et/ou d'une vitesse de rotation de l'élément en rotation à l'aide d'au moins un signal de capteur de phase provoqué par la position de la roue de capteur (116).

110

128

130
132

118

112, 122

114

134

β   α

136

116

120

**FIG. 1**

122

114

142      142

124, 138

126, 140

α/2

α

**FIG. 2**

122

126, 146

126, 144

114

124, 138

ξ

140, 142, 146

140, 142, 144

α/2

α

**FIG. 3**

112, 148

112, 148

114

112, 148

**FIG. 4**

134

116

118

**FIG. 5**     **A**          **B**

118

**FIG. 6**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102012213539 A1
- US 7449878 B2

- DE 102012200195 A1

**In der Beschreibung aufgeführte Nicht-Patentliteratur**

- Sensoren im Kraftfahrzeug. 2012, 63-74, 120-129